# EUROPEAN PATENT SPECIFICATION

(11) **EP 3 306 603 B1**
(45) Date of publication and mention of the grant of the patent: **15.07.2020**
(21) Application number: 15894787.9
(22) Date of filing: 10.11.2015
(51) Int. Cl.: G09G 3/36, G11C 19/28

(54) **SHIFT REGISTER UNIT AND DRIVE METHOD THEREFOR, GATE DRIVE CIRCUIT AND DISPLAY APPARATUS**
SCHIEBEREGISTER UND ANSTEUERUNGSVERFAHREN DAFÜR, GATE-TREIBERSCHALTUNG UND ANZEIGEVORRICHTUNG
UNITÉ DE REGISTRE À DÉCALAGE ET SON PROCÉDÉ D'ATTAQUE, CIRCUIT D'ATTAQUE DE GRILLE ET APPAREIL D'AFFICHAGE

(30) Priority: 08.06.2015 CN 201510309520
(43) Date of publication of application: 11.04.2018
(73) Proprietor: BOE Technology Group Co., Ltd., Beijing 100015 (CN); Beijing BOE Optoelectronics Technology Co., Ltd., Beijing 100176 (CN)
(72) Inventor: LI, Jinyu, Beijing 100176 (CN); CAO, Xue, Beijing 100176 (CN)
(74) Representative: Jacobacci Coralis Harle
(86) International application number: PCT/CN2015/094223
(87) International publication number: WO 2016/197531

(56) References cited:
- WO-A1-2010/097986
- CN-A- 102 800 289
- CN-A- 102 956 186
- CN-A- 103 985 341
- CN-A- 103 985 341
- CN-A- 103 996 370
- CN-A- 104 575 438
- CN-A- 104 835 475
- US-A1- 2006 145 999

## Description

This application claims the benefit and priority of Chinese Patent Application No. 201510309520.5 filed June 8, 2015.

### FIELD

The present disclosure relates to the field of display technology, and particularly, to a shift register unit and a driving method thereof, a gate driving circuit and a display device.

### BACKGROUND

A traditional manner for driving a display device is driving pixels on the display panel with an external drive chip to display an image. In order to reduce the number of elements and the manufacturing cost, in recent years, the technology of directly preparing a drive circuit structure onto a panel (e.g., integrating a gate driving circuit onto a liquid crystal panel (Gate On Array, abbreviated as GOA) has become a main stream.

Currently, such a drive circuit is usually driven with AC signals. Thus, there is unavoidable signal delay effect. Driving with AC signals increases power consumption of the drive circuit and decreases driving capabilities, and can hardly be applied to a large size liquid crystal display device.

Each of documents CN103985341 CN103996370 discloses (see figures 2,3 for the former document and figures 1,2 for the latter document) a shift register having an input module, a pull-down control module, a pull-down module, a pull-up module and a reset module mutually connected to each other. CN103985341 discloses separate carry and gate outputs from the pull-up module.

### SUMMARY

The invention is set out in the appended claims.

The embodiments of the disclosure provide a shift register unit and a driving method thereof, a gate driving circuit and a display device. DC voltage is used as input signals of the main transistor, leading to stable outputs, strong driving capabilities and a significant reduction of power consumption by the circuit in the pull-up phase and the pull-down phase.

According to a first aspect of the disclosure, there is provided a shift register unit comprising an input module, a pull-down control module, a pull-down module, a pull-up module and a reset module, wherein the input module is connected with the pull-up module, and configured to output a pull-up control signal to the pull-up module based on a first DC voltage signal and a start signal, wherein the pull-up module is configured to output a shift signal via a first output port and output a start signal for a next stage of shift register unit via a second output port, based on a second DC voltage signal and a clock signal, wherein the pull-down control module is connected with the pull-down module and the pull-up module, and configured to output a pull-down control signal to the pull-down module based on the second DC voltage signal, a third DC voltage signal and the clock signal, wherein the pull-down module is connected with the pull-up module, and configured to output to the pull-up module a pull-down signal for the first output port, the second output port and a pull-up point, and wherein the reset module is connected with the pull-up module, and configured to reset the pull-up module based on a fourth DC voltage signal and a reset signal.

In the embodiments of the disclosure, the input module includes a first transistor, wherein a control electrode of the first transistor is connected with an input port of the start signal, a first electrode of the first transistor is connected with an input port of the first DC voltage signal, and a connection point connecting a second electrode of the first transistor and the pull-up module forms the pull-up point.

In the embodiments of the disclosure, the pull-up module includes a third transistor, an eighth transistor and a first capacitor, wherein a control electrode of the third transistor is connected with the second electrode of the first transistor, a first electrode of the third transistor is connected with an input port of the second DC voltage signal, and a second electrode of the third transistor is connected with the pull-down module, and wherein the second electrode forms the first output port, wherein a control electrode of the eighth transistor is connected with the second electrode of the first transistor, a first electrode of the eighth transistor is connected with an input port of the clock signal, and a second electrode of the eighth transistor is connected with a second port of the first capacitor, and wherein a connection point connecting the second electrode of the eighth transistor and the second port of the first capacitor forms the second output port, wherein a first port of the capacitor is connected with the second electrode of the first transistor, and wherein a connection point connecting the second electrode of the first transistor, the control electrode of the third transistor, the control electrode of the eighth transistor and the first port of the first capacitor forms the pull-up point.

In the embodiments of the disclosure, the pull-down control module includes a fourth transistor, a fifth transistor, a sixth transistor and a ninth transistor, wherein a control electrode of the fourth transistor is connected with the input port of the clock signal, a first electrode of the fourth transistor is connected with a control electrode of the sixth transistor, and a second electrode of the fourth transistor is connected with an input port of the third DC voltage signal, wherein a control electrode and a first electrode of the fifth transistor are each connected with the input port of the second DC voltage signal, and a second electrode of the fifth transistor is connected with the control electrode of the sixth transistor, wherein a first electrode of the sixth transistor is connected with the input port of the second DC voltage signal, and a second electrode of the sixth transistor is connected with the pull-down module, and wherein a control electrode of the ninth transistor is connected with the second electrode of the first transistor, a first electrode of the ninth transistor is connected with the pull-down module, and a second electrode of the ninth transistor is connected with the input port of the third DC voltage signal.

In the embodiments of the disclosure, the pull-down module includes a seventh transistor, a tenth transistor, and an eleventh transistor, wherein a control electrode of the seventh transistor is connected with the second electrode of the sixth transistor, a first electrode of the seventh transistor is connected with the second port of the first capacitor, and a second electrode of the seventh transistor is connected with the input port of the third DC voltage signal, wherein a control electrode of the tenth transistor is connected with the second electrode of the sixth transistor, a first electrode of the tenth transistor is connected with the control electrode of the third transistor, and a second electrode of the tenth transistor is connected with the input port of the third DC voltage signal, wherein a control electrode of the eleventh transistor is connected with the second electrode of the sixth transistor, a first electrode of the eleventh transistor is connected with the second electrode of the third transistor, and a second electrode of the eleventh transistor is connected with the input port of the third DC voltage signal, and wherein, a connection point connecting the control electrode of the seventh transistor, the first electrode of the ninth transistor, the second electrode of the sixth transistor, the control electrode of the tenth transistor and the control electrode of the eleventh transistor forms a pull-down point.

In the embodiments of the disclosure, the reset module includes a second transistor, wherein a control electrode of the second transistor is connected with an input port of the reset signal, a first electrode of the second transistor is connected with the control electrode of the third transistor, and a second electrode of the second transistor is connected with an input port of the fourth DC voltage signal.

In the embodiments of the disclosure, all the transistors from the first transistor to the eleventh transistor are N-type transistors, or wherein all the transistors from the first transistor to the eleventh transistor are P-type transistors, or wherein a part of the transistors from the first transistor to the eleventh transistor are P-type transistors, and the others are N-type transistors.

According to a second aspect of the disclosure, there is provided a gate driving circuit comprising a plurality of shift register units above-mentioned, wherein the plurality of shift register units are connected in cascade, an input module of the shift register unit is inputted with an output signal outputted by the second output port of a previous stage of shift register unit, a reset module of the shift register unit is provided with an output signal outputted by the second output port of a next stage of shift register unit.

According to a third aspect of the disclosure, there is provided a display device comprising a gate driving circuit above-mentioned.

According to a fourth aspect of the disclosure, there is provided a driving method for driving the shift register unit, comprising: a pre-output phase: providing an effective start signal, wherein the pull-up point is charged, and a voltage of the pull-down point is at low level, the first output port outputs a shift signal of which a voltage rises gradually, and a voltage of the second output port is at low level, an output phase: providing an effective clock signal, wherein the charging of pull-up point is completed and a voltage of the pull-up point is at high level, the voltage of the pull-down point is maintained at low level, the first output port outputs a shift signal at high level, and the second output port outputs a start signal at high level for a next stage of shift register unit, a reset phase: providing an effective reset signal, wherein the voltage of the pull-up point is at low level, and the voltage of the pull-down point is at high level, the voltage of the second output port is reset to low level, and the first output port outputs a shift signal at low level, and a maintenance phase: providing an effective clock signal, wherein the voltage of the pull-down point is maintained at high level, and the shift signal outputted by the first output port and the voltage of the second output port are maintained at low level.

In the embodiments of the disclosure, the transistors in the shift register unit are N-type transistors, wherein in the pre-output phase, the start signal is at high level and the clock signal is at low level, the first transistor is ON to charge the pull-up point, the ninth transistor is ON to pull down the voltage of the pull-down point, the eighth transistor is ON, the voltage of the second output port is at low level, and the first output port outputs a shift signal of which the voltage rises gradually, wherein in the output phase, the start signal is at low level and the clock signal is at high level, the eighth transistor is inputted with the voltage of the pull-up point at high level, the voltage of the pull-up point continues to be pulled up and the third transistor is ON, the voltages of the first output port and the second output port are at high level, and the ninth transistor continues to be ON to maintain the voltage of the pull-down point at low level, wherein in the reset phase, the clock signal and the start signal are at low level, the reset signal is at high level, the voltage of the pull-up point is pulled down, the third transistor and the ninth transistor are OFF, the voltage of the pull-down point becomes at high level, the seventh transistor, the tenth transistor and the eleventh transistor are ON, the seventh transistor pulls down the voltage of the second output port, the tenth transistor further pulls down the voltage of the pull-up point, the eleventh transistor pulls down the voltage of the first output port, and the first output port outputs a shift signal at low level, wherein in the maintenance phase, the clock signal is at high level, the voltage of the pull-down point is at high level, the seventh transistor, the tenth transistor and the eleventh transistor maintain to be ON to stabilize the voltage of the pull-up point and maintain the shift signal outputted by the first output port at low level.

In the embodiments of the disclosure, the first DC voltage signal and the fourth DC voltage signal are DC voltage signals with opposite polarities, the second DC voltage signal is a positive voltage signal and the third DC voltage signal is a negative voltage signal.

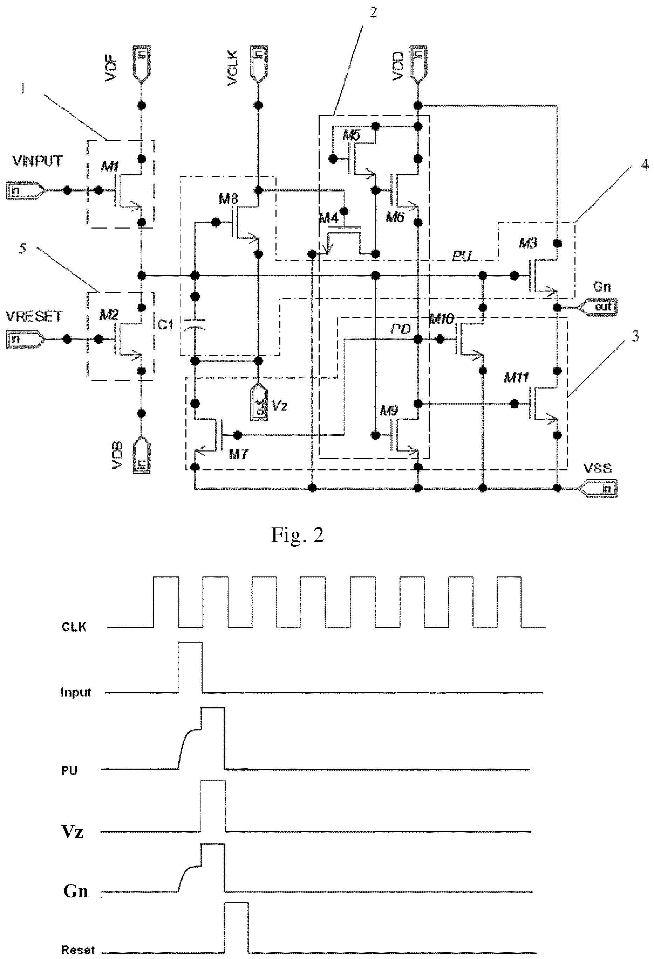

The shift register unit according to the embodiments of the disclosure uses DC voltage signals (the second DC voltage signal VDD) instead of AC signals as input signals of the pull-up module (i.e., the main transistor M3) and the pull-down control module. In comparison with the prior art using AC voltage signals as input signals, the embodiments of the disclosure have following advantages:
(1) AC signals cause RC delay during transmission, but DC signals do not cause RC delay, so signal delay effect can be reduced.
(2) AC signals cause RC delay, causing attenuation of signals, but DC signals do not have attenuation. Thus, DC signals have stronger driving capabilities than AC signals, and this strengthens driving capabilities.
(3) When driven by AC signals, a parasitic capacitor of the third transistor M3 itself is repeatedly charged and discharged, causing a loss of power. There is no repeated charging and discharging in the process of driving with DC signals, which thus greatly reduces power consumption by the drive circuit. Using DC voltage signals as input signals of the pull-down control module may reduce a number of transistors in case of AC signals, which thus may further reduce power consumption of the drive circuit, enhance the pull-down role of the pull-down point PD, and provide better pull-down capabilities and stable shift signal outputs.
(4) The shift register unit according to the embodiments of the disclosure may further achieve a pre-charging effect (see an oscillogram of the pull-up point PU in Fig.3).

In addition, the gate driving circuit with the shift register units according to the embodiments of the disclosure may achieve a bi-directional scanning function to make driving more flexible. Furthermore, the display device using the gate driving circuit according to the embodiments of the disclosure may have a small power consumption and present a better display effect.

### DRAWINGS

In order to illustrate the technical solutions of the embodiments of the disclosure more clearly, a brief introduction to figures of the embodiments is made as follows. Apparently, the following figures only relate to some embodiments of the disclosure, but do not limit the disclosure.
Fig. 1 is a schematic structure diagram of the shift register unit according to the embodiments of the disclosure,
Fig. 2 is a schematic circuit diagram of the shift register unit according to the embodiments of the disclosure,
Fig. 3 is a timing oscillogram of the shift register unit according to the embodiments of the disclosure,
Fig. 4 is a schematic structure diagram of the gate driving circuit according to the embodiments of the disclosure.

### DETAILED DESCRIPTION

In order to make technical problems to be solved, technical solutions and advantages of the embodiments of the disclosure clearer, a clear and complete description to the technical solutions of the disclosure shall be made in combination with figures of the embodiments of the disclosure. The embodiments to be described below are only some of embodiments, but not all the embodiments. Based on the described embodiments of the disclosure, those skilled in the art may obtain some other embodiments without creative work, but all the other embodiments shall fall within the protection scope of the disclosure.

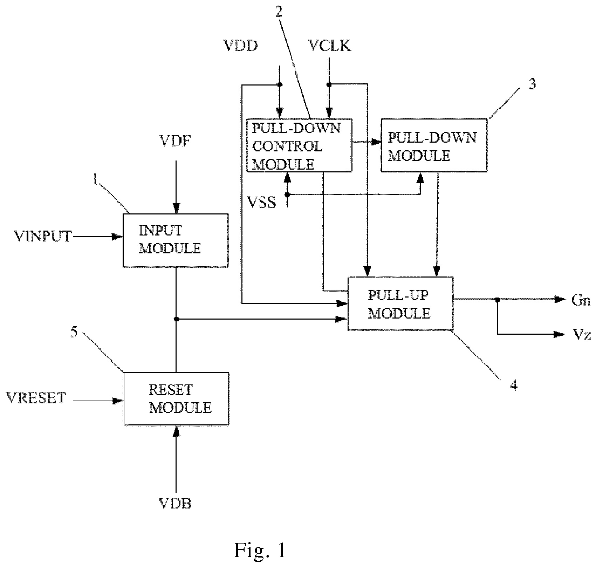

Fig. 1 is a schematic structure diagram of the shift register unit according to the embodiments of the disclosure. As shown by Fig. 1, the embodiments of the disclosure provide a shift register unit which uses DC voltage signals as input signals of the main transistor M3, leading to stable outputs and strong driving capabilities, and which uses DC voltage signals to control transistors of an input module 1 and a pull-down control module 2, significantly reducing power consumption by the circuit in the pull-up phase and the pull-down phase.

An input port of the shift register unit receives input voltage, and an output port thereof provides shift output voltage. The shift register unit comprises an input module 1, a pull-down control module 2, a pull-down module 3, a pull-up module 4 and a reset module 5. The pull-down control module 2 acts on the pull-down module 3. The pull-down module 3 acts on the pull-up module 4. The pull-up module 4 acts on the pull-down control module 2 via a pull-up point.

The input module 1 is connected with the pull-up module 4, and configured to output a pull-up control signal to the pull-up module 4 based on a first DC voltage signal VDF and a start signal Input. The pull-up module 4 is configured to output a shift signal Gn via a first output port out1 and output Vz as a start signal Input for a next stage of shift register unit via a second output port out2, based on a second DC voltage signal VDD and a clock signal CLK. The pull-down control module 2 is connected with the pull-down module 3 and the pull-up module 4, and configured to output a pull-down control signal to the pull-down module 3 based on the second DC voltage signal VDD, a third DC voltage signal VSS and the clock signal CLK. The pull-down module 3 is connected with the pull-up module 4, and configured to output to the pull-up module 4 a pull-down signal for the first output port out1, the second output port out2 and a pull-up point PU. The reset module 5 is connected with the pull-up module 4, and configured to reset the pull-up module 4 based on a fourth DC voltage signal VDB and a reset signal Reset.

Fig. 2 is a schematic circuit diagram of the shift register unit according to the embodiments of the disclosure. As shown by Fig. 2, the input module 1 includes a first transistor M1, a control electrode of the first transistor M1 is connected with an input port VINPUT of the start signal, a first electrode of the first transistor M1 is connected with an input port of the first DC voltage signal VDF, and a second electrode of the first transistor M1 is connected with the pull-up module 4.

The pull-up module 4 includes a third transistor M3, an eighth transistor M8 and a first capacitor C1. A control electrode of the third transistor M3 is connected with the second electrode of the first transistor M1, a first electrode of the third transistor M3 is connected with an input port of the second DC voltage signal VDD, and a second electrode of the third transistor M3 is connected with the pull-down module 3, wherein the second electrode of the third transistor M3 forms the first output port out1. A control electrode of the eighth transistor M8 is connected with the second electrode of the first transistor M1, a first electrode of the eighth transistor M8 is connected with an input port VCLK of the clock signal, and a second electrode of the eighth transistor M8 is connected with a second port of the first capacitor C1, wherein a connection point connecting the second electrode of the eighth transistor M8 and the second port of the first capacitor C1 forms the second output port out2. A first port of the first capacitor is connected with the second electrode of the first transistor M1. Connection point connecting the second electrode of the first transistor, the control electrode of the third transistor, the control electrode of the eighth transistor and the first port of the first capacitor forms the pull-up point PU.

The pull-down control module 2 includes a fourth transistor M4, a fifth transistor M5, a sixth transistor M6 and a ninth transistor M9. A control electrode of the fourth transistor M4 is connected with the input port VCLK of the clock signal, a first electrode of the fourth transistor M4 is connected with a control electrode of the sixth transistor M6, and a second electrode of the fourth transistor M4 is connected with an input port of the third DC voltage signal VSS. A control electrode and a first electrode of the fifth transistor M5 are each connected with the input port of the second DC voltage signal VDD, and a second electrode of the fifth transistor M5 is connected with the control electrode of the sixth transistor M6. A first electrode of the sixth transistor M6 is connected with the input port of the second DC voltage signal VDD, and a second electrode of the sixth transistor M6 is connected with the pull-down module 3. A control electrode of the ninth transistor M9 is connected with the second electrode of the first transistor M1, a first electrode of the ninth transistor M9 is connected with the pull-down module 3, and a second electrode of the ninth transistor M9 is connected with the input port of the third DC voltage signal VSS.

The pull-down module 3 includes a seventh transistor M7, a tenth transistor M10, and an eleventh transistor M11. A control electrode of the seventh transistor M7 is connected with the second electrode of the sixth transistor, a first electrode of the seventh transistor M7 is connected with the second port of the first capacitor C1, and a second electrode of the seventh transistor M7 is connected with the input port of the third DC voltage signal VSS. A control electrode of the tenth transistor M10 is connected with the second electrode of the sixth transistor M6, a first electrode of the tenth transistor M10 is connected with the control electrode of the third transistor M3, and a second electrode of the tenth transistor M10 is connected with the input port of the third DC voltage signal VSS. A control electrode of the eleventh transistor M11 is connected with the second electrode of the sixth transistor M6, a first electrode of the eleventh transistor M11 is connected with the second electrode of the third transistor M3, and a second electrode of the eleventh transistor M11 is connected with the input port of the third DC voltage signal VSS. A connection point connecting the control electrode of the seventh transistor, the first electrode of the ninth transistor, the second electrode of the sixth transistor, the control electrode of the tenth transistor and the control electrode of the eleventh transistor forms the pull-down point PD.

The reset module 5 includes a second transistor M2, a control electrode of the second transistor M2 is connected with the input port VRESET of the reset signal, a first electrode of the second transistor M2 is connected with the control electrode of the third transistor M3, a second electrode of the second transistor M2 is connected with an input port of the third DC voltage signal.

In the embodiments of the disclosure, all the transistors from the first transistor M1 to the eleventh transistor M11 are N-type transistors, or all the transistors from the first transistor M1 to the eleventh transistor M11 are P-type transistors, or a part of the transistors from the first transistor M1 to the eleventh transistor M11 are P-type transistors, and the others are N-type transistors, as long as corresponding ports of the transistors are correctly connected. In the shift register unit provided by the embodiment, all the transistors are illustrated by taking N-type transistors for instance. Those skilled in the art may conceive of replacing N-type transistors with P-type transistors without creative work, which thus falls within the protection scope of the embodiments of the disclosure.

Fig. 3 is a timing oscillogram of the shift register unit according to the embodiments of the disclosure. As shown by Fig.3, accordingly, the embodiments of the disclosure further provide a driving method for driving the shift register unit, comprising a pre-output phase, an output phase, a reset phase and a maintenance phase.

In the pre-output phase, the start signal Input is effective, the pull-up point PU is charged, and a voltage of the pull-down point PD is at low level, the first output port out1 outputs a shift signal Gn of which a voltage rises gradually, and a voltage of the second output port is at low level. In the output phase, a clock signal CLK is effective, the charging of the pull-up point PU is completed, a voltage of the pull-up point PU is at high level, the voltage of the pull-down point PD is maintained at low level, the first output port outputs a shift signal Gn at high level, and the second output port out2 outputs a start signal Input at high level for a next stage. In the reset phase, a reset signal Reset is effective, the voltage of the pull-down point PD is at high level, the voltage of the pull-up point PU is at low level. The voltage of the second output port out2 is reset to low level, and the first output port out1 outputs a shift signal Gn at low level. In the maintenance phase, the clock signal CLK is effective, the voltage of the pull-down point PD is maintained at high level, and a shift signal Gn outputted by the first output port out1 and the voltage of the second output port are maintained at low level.

In the embodiments of the disclosure, a further description is made by taking all the transistors from the first transistorM1 to the eleventh transistor M11 being N-type transistors for instance.

In the driving method for driving the shift register unit, at the initial moment, both the start signal Input and the clock signal CLK are at low level, and the voltages of the first output port out1 and the second output port out2 are at low level.

In the pre-output phase, the start signal Input is at high level and the clock signal CLK is at low level, the first transistor M1 is ON to charge the pull-up point PU, when voltage of the pull-down point is high, the ninth transistor M9 is ON to pull down the voltage of the pull-down point PD, the eighth transistor M8 is ON, the first output port out1 outputs a shift signal of which a voltage rises gradually, the second output port out2 outputs low level.

In the output phase, the start signal Input is at low level and the clock signal CLK is at high level, the control electrode of the eighth transistor M8 is inputted with the voltage of the pull-up point PU at high level, the voltage of the pull-up point PU continues to be pulled up by a bootstrap effect of the first capacitor C1, and the third transistor M3 is ON, the voltages of the first output port out1 and the second output port out2 are at high level, and because the voltage of the pull-up point PU is at high level, the ninth transistor M9 continues to be ON to maintain the voltage of the pull-down point PD at low level.

In the reset phase, the clock signal CLK and the start signal Input are at low level, the reset signal Reset is at high level, the second transistor M2 is ON, the fourth DC voltage signal VDB has a DC negative voltage, the voltage of the pull-up point PU is pulled down, the third transistor M3 and the ninth transistor M9 are OFF, the voltage of the pull-down point PD becomes at high level due to an effect from the second DC voltage signal VDD, the tenth transistor M10 and the eleventh transistor M11 are ON, the tenth transistor M10 further pulls down the voltage of the pull-up point PU, the eleventh transistor M11 pulls down the voltage of the first output port out1, the voltage of the first output port out1 is at low level, the seventh transistor M7 is ON and pulls down the voltage of the second output port out2, namely, a start signal Input, i.e., Vz, for the next stage of the shift register unit.

In the maintenance phase, the clock signal CLK is at high level, at this time, the sixth transistor is not OFF, the fourth transistor M4 being ON can only cause a drop of gate electrode voltage of the sixth transistor M6, but the sixth transistor M6 will not be OFF, the voltage of the pull-down point PD is at high level, the seventh transistor M7, the tenth transistor M10 and the eleventh transistor M11 maintain ON to stabilize the voltage of the pull-up point PU and maintain the signal outputted by the first output port out1 at low level.

In the aforesaid process, the pull-down point PD maintains at high level except in the pre-output phase and the output phase. The shift register unit performs a shift register function in the aforesaid order.

In the driving method for driving the shift register unit, the first DC voltage signal VDF and the fourth DC voltage signal VDB are DC voltage signals with opposite polarities, the second DC voltage signal VDD is a positive voltage signal and the third DC voltage signal VSS is a negative voltage signal. For example, when VDF is a DC positive voltage signal and VDB is a DC negative voltage signal, VDF is for starting voltage and VDB is for resetting voltage, when VDF is a DC negative voltage signal and VDB is a DC positive voltage signal, VDF is for resetting voltage and VDB is for starting voltage.

The shift register unit above uses DC voltage signals (the second DC voltage signal VDD) instead of AC signals as input signals of the main transistor M3. In comparison with using AC voltage signals as input signals, the embodiments of the disclosure has the following advantages:
(1) AC signals cause RC delay during transmission, but DC signals do not cause RC delay, so signal delay effect can be reduced.
(2) AC signals cause RC delay, causing attenuation of signals, but DC signals do not have attenuation. Thus, DC signals have stronger driving capabilities than AC signals, and this strengthens driving capabilities.
(3) When driven by AC signals, a parasitic capacitor of the third transistor M3 itself is repeatedly charged and discharged, causing a loss of power. There is no repeated charging and discharging in the process of driving with DC signals, which thus greatly reduces power consumption by the drive circuit. Using DC voltage signals as input signals of the pull-down control module may reduce a number of transistors in case of AC signals, which thus may further reduce power consumption of the drive circuit, enhance the pull-down role of the pull-down point PD, and provide better pull-down capabilities and stable shift signal outputs.
(4) The shift register unit may further achieve a pre-charging effect (see an oscillogram of the pull-up point PU in Fig.3).
(5) In a liquid display device having a large size, a gate driving circuit composed of a plurality of the shift register units connected in cascade may be used.

The embodiments of the disclosure provide a gate driving circuit, comprising the shift register unit above.

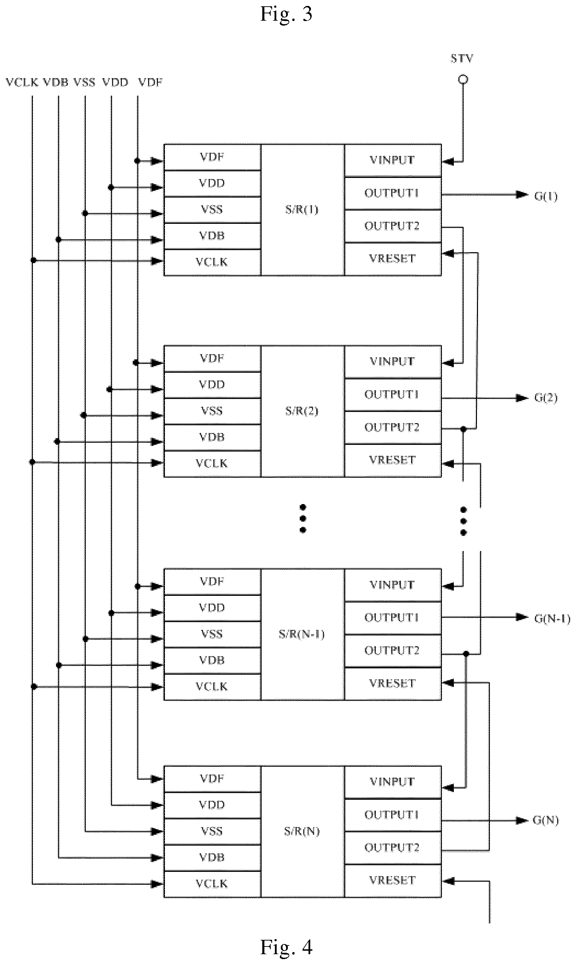

Fig. 4 is a schematic structure diagram of the gate driving circuit according to the embodiments of the disclosure. As shown by Fig.4, in the gate driving circuit, the input module of the shift register unit at each level controls a signal connection path based on a potential level of the start signal Input, and controls a signal connection path between the DC voltage signal and the output port by a potential level of the pull-up point PU to provide shift signal outputs. Specifically, in the gate driving circuit, a plurality of shift register units are connected in cascade. The output signal Vz outputted by the second output port OUTPUT2 (i.e., out2) is used as a transmission signal. The input module (i.e., the input port VINPUT of the start signal) of a shift register unit is inputted with an output signal Vz outputted by the second output port OUTPUT2 of a previous stage of shift register unit. The reset module (i.e., the input port VRESET of the reset signal) of a shift register unit is provided with an output signal Vz outputted by the second output port OUTPUT2 of a next stage of shift register unit.

Wherein, the second electrode of the first transistor M1 is connected with the first electrode of the second transistor M2. When a scanning sequence is changed, roles of the first transistor M1 in the input module and the second transistor M2 in the reset module are mutually exchanged. That is, if the scanning sequence is reversed, it is only necessary to exchange the start signal Input and the reset signal Reset, change the first triggered GOA unit, and exchange high level and low level of the first DC voltage signal VDF and the fourth DC voltage signal VDB, then, a reverse scanning function can be achieved. For example, during a forward scanning, VDF is a DC positive voltage signal and VDB is a DC negative voltage signal, and during a reverse scanning, VDF is a DC negative voltage signal and VDB is a DC positive voltage signal.

The gate driving circuit in the embodiment has the following advantages:
(1) The shift register units use DC voltage as input signals of the main transistor M3, leading to stable outputs, and strong driving capabilities which are suitable for driving a liquid crystal display device having a large size.
(2) DC signals are used to control transistors of the input module 1 and the pull-down control module 2 of the shift register units, which may significantly reduce power consumption by the circuit in the pull-up phase and the pull-down phase.
(3) A bi-directional scanning function may be achieved to make driving more flexible.

The embodiments of the disclosure provide a display device, comprising the gate driving circuit above-mentioned.

The display device may be any product or component having a display function, such as, liquid crystal panel, electronic paper, OLED panel, mobile telephone, tablet computer, television, display device, laptop, digital photo frame and/or navigator and the like.

The display device may be a display panel having a large size, a small power consumption, and a good display effect.

It is understandable that the aforesaid embodiments are only exemplary embodiments for illustrating the principle of the disclosure, and that modifications of the disclosure may be made within the scope of the appended claims.

## Claims

1. A shift register unit comprising an input module (1), a pull-down control module (2), a pull-down module (3), a pull-up module (4) and a reset module (5),
wherein the input module (1) is connected with the pull-up module (4), and configured to output a pull-up control signal to the pull-up module (4) based on a first DC voltage signal (VDF) and a start signal (VINPUT),
wherein the pull-up module (4) is configured to output a shift signal (Gn) via a first output port and output a start signal (Vz) for a next stage of shift register unit via a second output port, based on a second DC voltage signal (VDD) and a clock signal (VCLK),
wherein the pull-down control module (2) is connected with the pull-down module (3) and the pull-up module (4), and configured to output a pull-down control signal to the pull-down module (3) based on the second DC voltage signal, a third DC voltage signal (VSS) and the clock signal,
wherein the pull-down module (3) is connected with the pull-up module (4), and configured to output to the pull-up module (4) a pull-down signal for the first output port, the second output port and a pull-up point, and
wherein the reset module (5) is connected with the pull-up module (4), and configured to reset the pull-up module (4) based on a fourth DC voltage signal (VDB) and a reset signal (VRESET) ;
wherein the input module (1) includes a first transistor (M1), wherein a control electrode of the first transistor (M1) is connected with an input port of the start signal, a first electrode of the first transistor (M1) is connected with an input port of the first DC voltage signal, and a connection point connecting a second electrode of the first transistor (M1) and the pull-up module (4) forms the pull-up point (PU);
wherein the pull-up module (4) includes a third transistor (M3), an eighth transistor (M8) and a first capacitor (C1),
wherein a control electrode of the third transistor (M3) is connected with the second electrode of the first transistor (M1), a first electrode of the third transistor (M3) is connected with an input port of the second DC voltage signal, and a second electrode of the third transistor (M3) is connected with the pull-down module (3), and wherein the second electrode of the third transistor forms the first output port,
wherein a control electrode of the eighth transistor (M8) is connected with the second electrode of the first transistor (M1), a first electrode of the eighth transistor (M8) is connected with an input port of the clock signal, and a second electrode of the eighth transistor (M8) is connected with a second port of the first capacitor, and wherein a connection point connecting the second electrode of the eighth transistor (M8) and the second port of the first capacitor forms the second output port,
wherein a first port of the capacitor is connected with the second electrode of the first transistor (M1), and
wherein a connection point connecting the second electrode of the first transistor (M1), the control electrode of the third transistor (M3), the control electrode of the, eighth transistor (M8) and the first port of the first capacitor forms the pull-up point;
wherein:
the pull-down control module (2) includes a fourth transistor (M4), a fifth transistor (M5), a sixth transistor (M6) and a ninth transistor (M9),
wherein a control electrode of the fourth transistor (M4) is connected with the input port of the clock signal, a first electrode of the fourth transistor (M4) is connected with a control electrode of the sixth transistor (M6), and a second electrode of the fourth transistor (M4) is connected with an input port of the third DC voltage signal,
wherein a control electrode and a first electrode of the fifth transistor (M5) are each connected with the input port of the second DC voltage signal, and a second electrode of the fifth transistor (M5) is connected with the control electrode of the sixth transistor (M6),
wherein a first electrode of the sixth transistor (M6) is connected with the input port of the second DC voltage signal, and a second electrode of the sixth transistor (M6) is connected with the pull-down module (3), and
wherein a control electrode of the ninth transistor (M9) is connected with the second electrode of the first transistor (M1) of the input module (1), a first electrode of the ninth transistor (M9) is connected with the pull-down module (3), and a second electrode of the ninth transistor (M9) is connected with the input port of the third DC voltage signal;
wherein the pull-down module (3) includes a seventh transistor (M7), a tenth transistor (M10), and an eleventh transistor (M11),
wherein a control electrode of the seventh transistor (M7) is connected with the second electrode of the sixth transistor (M6), a first electrode of the seventh transistor (M7) is connected with the second port of the first capacitor of the pull-up module (4), and a second electrode of the seventh transistor (M7) is connected with the input port of the third DC voltage signal,
wherein a control electrode of the tenth transistor (M10) is connected with the second electrode of the sixth transistor (M6), a first electrode of the tenth transistor (M10) is connected with the control electrode of the third transistor (M3) of the pull-up module (4), and a second electrode of the tenth transistor (M10) is connected with the input port of the third DC voltage signal,
wherein a control electrode of the eleventh transistor (M11) is connected with the second electrode of the sixth transistor (M6), a first electrode of the eleventh transistor (M11) is connected with the second electrode of the third transistor (M3), and a second electrode of the eleventh transistor (M11) is connected with the input port of the third DC voltage signal, and
wherein, a connection point connecting the control electrode of the seventh transistor (M7), the first electrode of the ninth transistor (M9), the second electrode of the sixth transistor (M6), the control electrode of the tenth transistor (M10) and the control electrode of the eleventh transistor (M11) forms a pull-down point (PD).

2. The shift register unit according to claim 1, wherein the reset module (5) includes a second transistor (M2), wherein a control electrode of the second transistor (M2) is connected with an input port of the reset signal, a first electrode of the second transistor (M2) is connected with the control electrode of the third transistor (M3), and a second electrode of the second transistor (M2) is connected with an input port of the fourth DC voltage signal.

3. The shift register unit according to claim 2, wherein all the transistors from the first transistor (M1) to the eleventh transistor (M11) are N-type transistors, or
wherein all the transistors from the first transistor (M1) to the eleventh transistor (M11) are P-type transistors, or
wherein a part of the transistors from the first transistor (M1) to the eleventh transistor (M11) are P-type transistors, and the others are N-type transistors.

4. A gate driving circuit comprising a plurality of shift register units according to any of claims 1-3, wherein the plurality of shift register units are connected in cascade,
wherein the input module (1) of a shift register unit is inputted with the output signal outputted by the second output port of a previous stage of shift register unit, and the reset module (5) of the shift register unit is provided with the output signal outputted by the second output port of a next stage of shift register unit.

5. A display device comprising a gate driving circuit according to claim 4.

6. A driving method for driving a shift register unit according to any of claims 1-3, comprising:
- a pre-output phase: providing an effective start signal being a high level pulse of the start signal (VINPUT), wherein the pull-up point is charged, and a voltage of the pull-down point is at low level, the first output port outputs the shift signal of which a voltage rises gradually, and a voltage of the second output port is at low level,
- an output phase: providing an effective clock signal being a high level pulse of the clock signal, wherein the charging of pull-up point is completed and a voltage of the pull-up point is at high level, the voltage of the pull-down point is maintained at low level, the first output port outputs the shift signal at high level, and the second output port outputs the start signal for a next stage of shift register unit at high level,
- a reset phase: providing an effective reset signal being a high level pulse of the reset signal, wherein the voltage of the pull-up point is at low level, and the voltage of the pull-down point is at high level, the voltage of the second output port is reset to low level, and the first output port outputs the shift signal at low level, and
- a maintenance phase: providing the effective clock signal, wherein the voltage of the pull-down point is maintained at high level, and the shift signal outputted by the first output port and the voltage of the second output port are maintained at low level;
wherein the transistors in the shift register unit are N-type transistors, and:
- in the pre-output phase, the start signal is at high level and the clock signal is at low level, the first transistor (M1) is ON to charge the pull-up point, the ninth transistor (M9) is ON to pull down the voltage of the pull-down point, the eighth transistor (M8) is ON, the voltage of the second output port is at low level, and the first output port outputs the shift signal of which the voltage rises gradually,
- in the output phase, the start signal is at low level and the clock signal is at high level, the eighth transistor (M8) is inputted with the voltage of the pull-up point at high level, the voltage of the pull-up point continues to be pulled up and the third transistor (M3) is ON, the voltages of the first output port and the second output port are at high level, and the ninth transistor (M9) continues to be ON to maintain the voltage of the pull-down point at low level,
- in the reset phase, the clock signal and the start signal are at low level, the reset signal is at high level, the voltage of the pull-up point is pulled down, the third transistor (M3) and the ninth transistor (M9) are OFF, the voltage of the pull-down point becomes at high level, the seventh transistor (M7), the tenth transistor (M10) and the eleventh transistor (M11) are ON, the seventh transistor (M7) pulls down the voltage of the second output port, the tenth transistor (M10) further pulls down the voltage of the pull-up point, the eleventh transistor (M11) pulls down the voltage of the first output port, and the first output port outputs the shift signal at low level,
- in the maintenance phase, the clock signal is at high level, the voltage of the pull-down point is at high level, the seventh transistor (M7), the tenth transistor (M10) and the eleventh transistor (M11) maintain to be ON to stabilize the voltage of the pull-up point and maintain the shift signal outputted by the first output port at low level.

7. The driving method according to claim 6, wherein the first DC voltage signal and the fourth DC voltage signal are DC voltage signals with opposite polarities, the second DC voltage signal is a positive voltage signal and the third DC voltage signal is a negative voltage signal.

## Patentansprüche

1. Schieberegistereinheit mit einem Eingangsmodul (1), einem Pull-down-Steuermodul (2), einem Pull-down-Modul (3), einem Pull-up-Modul (4) und einem Reset-Modul (5),
wobei das Eingangsmodul (1) mit dem Pull-up-Modul (4) verbunden ist und dazu ausgelegt ist, auf der Grundlage eines ersten Gleichspannungssignals (VDF) und eines Startsignals (VINPUT) ein Pull-up-Steuersignal an das Pull-up-Modul (4) abzugeben,
wobei das Pull-up-Modul (4) dazu ausgelegt ist, ein Schiebesignal (Gn) über einen ersten Ausgang abzugeben und auf der Grundlage eines zweiten Gleichspannungssignals (VDD) und eines Taktsignals (VCLK) ein Startsignal (Vz) für eine anschließende Stufe der Schieberegistereinheit über einen zweiten Ausgang abzugeben,
wobei das Pull-down-Steuermodul (2) mit dem Pull-down-Modul (3) und dem Pull-up-Modul (4) verbunden ist und dazu ausgelegt ist, auf der Grundlage des zweiten Gleichspannungssignals, eines dritten Gleichspannungssignals (VSS) und des Taktsignals ein Pull-down-Steuersignal an das Pull-down-Modul (3) abzugeben,
wobei das Pull-down-Modul (3) mit dem Pull-up-Modul (4) verbunden ist und dazu ausgelegt ist, an das Pull-up-Modul (4) ein Pull-down-Signal für den ersten Ausgang, den zweiten Ausgang und einen Pull-up-Punkt abzugeben, und
wobei das Reset-Modul (5) mit dem Pull-up-Modul (4) verbunden ist und dazu ausgelegt ist, das Pull-up-Modul (4) auf der Grundlage eines vierten Gleichspannungssignals (VDB) und eines Reset-Signals (VRESET) zurückzusetzen,
wobei das Eingangsmodul (1) einen ersten Transistor (M1) aufweist, wobei eine Steuerelektrode des ersten Transistors (M1) mit einem Eingang für das Startsignal verbunden ist, eine erste Elektrode des ersten Transistors (M1) mit einem Eingang für das erste Gleichspannungssignal verbunden ist, und ein Verbindungspunkt, der eine zweite Elektrode des ersten Transistors (M1) mit dem Pull-up-Modul (4) verbindet, den Pull-up-Punkt (PU) bildet,
wobei das Pull-up-Modul (4) einen dritten Transistor (M3), einen achten Transistor (M8) und einen ersten Kondensator (C1) aufweist,
wobei eine Steuerelektrode des dritten Transistors (M3) mit der zweiten Elektrode des ersten Transistors (M1) verbunden ist, eine erste Elektrode des dritten Transistors (M3) mit einem Eingang für das zweite Gleichspannungssignal verbunden ist und eine zweite Elektrode des dritten Transistors (M3) mit dem Pull-down-Modul (3) verbunden ist, und wobei die zweite Elektrode des dritten Transistors den ersten Ausgang bildet,
wobei eine Steuerelektrode des achten Transistors (M8) mit der zweiten Elektrode des ersten Transistors (M1) verbunden ist, eine erste Elektrode des achten Transistors (M8) mit einem Eingangsanschluß für das Taktsignal verbunden ist, und eine zweite Elektrode des achten Transistors (M8) mit einem zweiten Anschluß des ersten Kondensators verbunden ist, und wobei ein Verbindungspunkt, der die zweite Elektrode des achten Transistors (M8) mit dem zweiten Anschluß des ersten Kondensators verbindet, den zweiten Ausgangsanschluß bildet,
wobei ein erster Anschluß des Kondensators mit der zweiten Elektrode des ersten Transistors (M1) verbunden ist, und
wobei ein Verbindungspunkt, der die zweite Elektrode des ersten Transistors (M1), die Steuerelektrode des dritten Transistors (M3), die Steuerelektrode des achten Transistors (M8) und den ersten Anschluß des ersten Kondensators verbindet, den Pull-up-Punkt bildet,
wobei das Pull-down-Steuermodul (2) einen vierten Transistor (M4), einen fünften Transistor (M5), einen sechsten Transistor (M6) und einen neunten Transistor (M9) aufweist,
wobei eine Steuerelektrode des vierten Transistors (M4) mit dem Eingangsanschluß für das Taktsignal verbunden ist, eine erste Elektrode des vierten Transistors (M4) mit einer Steuerelektrode des sechsten Transistors (M6) verbunden ist und eine zweite Elektrode des vierten Transistors (M4) mit einem Eingangsanschluß für das dritte Gleichspannungssignal verbunden ist,
wobei eine Steuerelektrode und eine erste Elektrode des fünften Transistors (M5) jeweils mit dem Eingangsanschluß für das zweite Gleichspannungssignal verbunden sind und eine zweite Elektrode des fünften Transistors (M5) mit der Steuerelektrode des sechsten Transistors (M6) verbunden ist,
wobei eine erste Elektrode des sechsten Transistors (M6) mit dem Eingangsanschluß für das zweite Gleichspannungssignal verbunden ist und eine zweite Elektrode des sechsten Transistors (M6) mit dem Pull-down-Modul (3) verbunden ist und
wobei eine Steuerelektrode des neunten Transistors (M9) mit der zweiten Elektrode des ersten Transistors (M1) des Eingangsmoduls (1) verbunden ist, eine erste Elektrode des neunten Transistors (M9) mit dem Pull-down-Modul (3) verbunden ist und eine zweite Elektrode des neunten Transistors (M9) mit dem Eingangsanschluß für das dritte Gleichspannungssignal verbunden ist,
wobei das Pull-down-Modul (3) einen siebenten Transistor (M7), einen zehnten Transistor (M10) und einen elften Transistor (M11) aufweist,
wobei eine Steuerelektrode des siebenten Transistors (M7) mit der zweiten Elektrode des sechsten Transistors (M6) verbunden ist, eine erste Elektrode des siebenten Transistors (M7) mit dem zweiten Anschluß des ersten Kondensators des Pull-up-Moduls (4) verbunden ist und eine zweite Elektrode des siebenten Transistors (M7) mit dem Eingangsanschluß für das dritte Gleichspannungssignal verbunden ist,
wobei eine Steuerelektrode des zehnten Transistors (M10) mit der zweiten Elektrode des sechsten Transistors (M6) verbunden ist, eine erste Elektrode des zehnten Transistors (M10) mit der Steuerelektrode des dritten Transistors (M3) des Pull-up-Moduls (4) verbunden ist und eine zweite Elektrode des zehnten Transistors (M10) mit dem Eingangsanschluß für das dritte Gleichspannungssignal verbunden ist,
wobei eine Steuerelektrode des elften Transistors (M11) mit der zweiten Elektrode des sechsten Transistors (M6) verbunden ist, eine erste Elektrode des elften Transistors (M11) mit der zweiten Elektrode des dritten Transistors (M3) verbunden ist und eine zweite Elektrode des elften Transistors (M11) mit dem Eingangsanschluß für das dritte Gleichspannungssignal verbunden ist, und
wobei ein Verbindungspunkt, der die Steuerelektrode des siebenten Transistors (M7), die erste Elektrode des neunten Transistors (M9), die zweite Elektrode des sechsten Transistors (M6), die Steuerelektrode des zehnten Transistors (M10) und die Steuerelektrode des elften Transistors (M11) verbindet, einen Pull-down-Punkt (PD) bildet.

2. Schieberegistereinheit gemäß Anspruch 1, **dadurch gekennzeichnet, daß** das Reset-Modul (5) einen zweiten Transistor (M2) aufweist, wobei eine Steuerelektrode des zweiten Transistors (M2) mit einem Eingangsanschluß für das Reset-Signal verbunden ist, eine erste Elektrode des zweiten Transistors (M2) mit der Steuerelektrode des dritten Transistors (M3) verbunden ist und eine zweite Elektrode des zweiten Transistors (M2) mit einem Eingangsanschluß für das vierte Gleichspannungssignal verbunden ist.

3. Schieberegistereinheit gemäß Anspruch 2, **dadurch gekennzeichnet, daß** alle Transistoren vom ersten Transistor (M1) bis zum elften Transistor (11) Transistoren vom n-Typ sind, oder
daß alle Transistoren vom ersten Transistor (M1) bis zum elften Transistor (11) Transistoren vom p-Typ sind oder
daß ein Teil der Transistoren vom ersten Transistor (M1) bis zum elften Transistor (11) Transistoren vom p-Typ sind und die anderen Transistoren vom n-Typ sind.

4. Gate-Treiberschaltung mit einer Anzahl Schieberegistereinheiten gemäß einem der Ansprüche 1 bis 3, **dadurch gekennzeichnet, daß** die Anzahl Schieberegistereinheiten kaskadenartig verbunden sind, wobei das Eingangsmodul (1) einer Schieberegistereinheit das vom zweiten Ausgang einer vorangehenden Schieberegistereinheitsstufe abgegebene Ausgangssignal empfängt und das Reset-Modul (5) der Schieberegistereinheit das vom zweiten Ausgangsanschluß einer anschließenden Schieberegistereinheitsstufe abgegebene Ausgangssignal empfängt.

5. Anzeigevorrichtung mit einer Gate-Treiberschaltung gemäß Anspruch 4.

6. Ansteuerungsverfahren zum Ansteuern einer Schieberegistereinheit gemäß einem der Ansprüche 1 bis 3, mit
- einem Vorlauf zur Ausgangsphase, der ein effektives Startsignal liefert, das ein Hochniveauimpuls des Startsignals (VINPUT) ist,
wobei der Pull-up-Punkt geladen wird, und eine Spannung des Pull-down-Punkts auf unterem Niveau ist, der erste Ausgangsanschluß das Shift-Signal abgibt, aus dem stufenweise eine Spannung erwächst, und eine Spannung des zweiten Ausgangsanschlusses auf unterem Niveau ist,
- einer Ausgangsphase, die ein effektives Taktsignal liefert, das ein Hochniveauimpuls des Taktsignals ist,
wobei das Laden des Pull-up-Punktes abgeschlossen wird und eine Spannung des Pull-up-Punkts auf dem oberen Niveau ist, die Spannung des Pull-down-Punkts auf dem unteren Niveau gehalten wird, der erste Ausgangsanschluß das Shiftsignal auf dem oberen Niveau abgibt und der zweite Ausgangsanschluß das Startsignal für eine nächste Stufe der Schieberegistereinheit auf dem oberen Niveau abgibt,
- einer Reset-Phase, die ein effektives Resetsignal abgibt, das ein Hochniveauimpuls des Resetsignals ist,
wobei die Spannung des Pull-up-Punkts auf dem unteren Niveau ist und die Spannung des Pull-down-Punkts auf dem oberen Niveau ist, die Spannung des zweiten Ausgangsanschlusses auf das untere Niveau zurückgestellt wird, und der erste Ausgangsanschluß das Taktsignal auf dem unteren Niveau abgibt, und
- einer Haltephase, die das effektive Taktsignal liefert, wobei die Spannung des Pull-down-Punkts auf dem oberen Niveau gehalten wird und das vom ersten Ausgangsanschluß abgegebene Shiftsignal und die Spannung des zweiten Ausgangsanschlusses auf dem unteren Niveau gehalten werden,
wobei die Transistoren in der Schieberegistereinheit Transistoren vom n-Typ sind, und
- in der Vorausgangsphase das Startsignal auf dem oberen Niveau ist und das Taktsignal auf dem unteren Niveau ist, der erste Transistor (M1) auf ON ist, um den Pull-up-Punkt zu laden, der neunte Transistor (M9) auf ON ist, um die Spannung des Pull-down-Punkts herunterzuziehen, der achte Transistor (M8) auf ON ist, die Spannung des zweiten Ausgangsanschlusses auf dem unteren Niveau ist und der erste Ausgangsanschluß das Shiftsignal abgibt, dessen Spannung stufenweise ansteigt,
- in der Ausgangsphase das Startsignal auf dem unteren Niveau ist und das Taktsignal auf dem oberen Niveau ist, der achte Transistor (M8) die Spannung des Pull-up-Punkts auf dem oberen Niveau erhält, die Spannung des Pull-up-Punkts weiterhin nach oben gezogen wird und der dritte Transistor (M3) auf ON ist, die Spannungen des ersten Ausgangsanschlusses und des zweiten Ausgangsanschlusses auf dem oberen Niveau sind und der neunte Transistor (M9) weiterhin auf ON ist, um die Spannung des Pull-down-Punkts auf dem unteren Niveau zu halten,
- in der Resetphase das Taktsignal und das Startsignal auf dem unteren Niveau sind, das Resetsignal auf dem oberen Niveau ist, die Spannung des Pull-up-Punkts heruntergezogen wird, der dritte Transistor (M3) und der neunte Transistor (M9) auf OFF sind, die Spannung des Pull-down-Punkts auf das obere Niveau geht, der siebente Transistor (M7), der zehnte Transistor (M10) und der elfte Transistor (M11) auf ON sind, der siebente Transistor (M7) die Spannung des zweiten Ausgangsanschlusses herunterzieht, der zehnte Transistor (M10) darüber hinaus die Spannung des Pull-up-Punkts herunterzieht, der elfte Transistor (M11) die Spannung des ersten Ausgangsanschlusses herunterzieht und der erste Ausgangsanschluß das Shiftsignal auf dem unteren Niveau abgibt,
- in der Haltephase das Taktsignal auf dem oberen Niveau ist, die Spannung des Pull-down-Punkts auf dem oberen Niveau ist, der siebente Transistor (M7), der zehnte Transistor (M10) und der elfte Transistor (M11) auf ON bleiben, um die Spannung des Pull-up-Punkts zu stabilisieren und das vom ersten Ausgangsanschluß abgegebene Shiftsignal auf dem unteren Niveau zu halten.

7. Ansteuerungsverfahren gemäß Anspruch 6, **dadurch gekennzeichnet, daß** das erste Gleichspannungssignal und das vierte Gleichspannungssignal Gleichspannungssignale mit entgegengesetzter Polarität sind, das zweite Gleichspannungssignal ein positives Spannungssignal ist und das dritte Gleichspannungssignal ein negatives Spannungssignal ist.

## Revendications

1. Unité de registre à décalage comprenant un module d'entrée (1), un module de commande de rappel vers le niveau bas (2), un module de rappel vers le niveau bas (3), un module de rappel vers le niveau haut (4) et un module de réinitialisation (5),
le module d'entrée (1) étant raccordé au module de rappel vers le niveau haut (4) et étant configuré pour envoyer un signal de commande de rappel vers le niveau haut au module de rappel vers le niveau haut (4) en fonction d'un premier signal de tension continue (VDF) et d'un signal de démarrage (VINPUT),
le module de rappel vers le niveau haut (4) étant configuré pour émettre un signal de décalage (Gn) via un premier port de sortie et émettre un signal de démarrage (Vz) à destination d'un étage d'unité de registre à décalage suivant via un deuxième port de sortie, en fonction d'un deuxième signal de tension continue (VDD) et d'un signal d'horloge (VCLK),
le module de commande de rappel vers le niveau bas (2) étant raccordé au module de rappel vers le niveau bas (3) et au module de rappel vers le niveau haut (4) et étant configuré pour envoyer un signal de commande de rappel vers le niveau bas au module de rappel vers le niveau bas (3) en fonction du deuxième signal de tension continue, d'un troisième signal de tension continue (VSS) et du signal d'horloge,
le module de rappel vers le niveau bas (3) étant raccordé au module de rappel vers le niveau haut (4) et étant configuré pour envoyer au module de rappel vers le niveau haut (4) un signal de rappel vers le niveau bas pour le premier port de sortie, le deuxième port de sortie et un point de rappel vers le niveau haut, et
le module de réinitialisation (5) étant raccordé au module de rappel vers le niveau haut (4) et étant configuré pour réinitialiser le module de rappel vers le niveau haut (4) en fonction d'un quatrième signal de tension continue (VDB) et d'un signal de réinitialisation (VRESET) ;
le module d'entrée (1) incluant un premier transistor (M1), une électrode de commande du premier transistor (M1) étant raccordée à un port d'entrée du signal de démarrage, une première électrode du premier transistor (M1) étant raccordée à un port d'entrée du premier signal de tension continue, et un point de raccordement raccordant une deuxième électrode du premier transistor (M1) et du module de rappel vers le niveau haut (4) formant le point de rappel vers le niveau haut (PU) ;
le module de rappel vers le niveau haut (4) incluant un troisième transistor (M3), un huitième transistor (M8) et un premier condensateur (C1),
une électrode de commande du troisième transistor (M3) étant raccordée à la deuxième électrode du premier transistor (M1), une première électrode du troisième transistor (M3) étant raccordée à un port d'entrée du deuxième signal de tension continue, et une deuxième électrode du troisième transistor (M3) étant raccordée au module de rappel vers le niveau bas (3), et la deuxième électrode du troisième transistor formant le premier port de sortie,
une électrode de commande du huitième transistor (M8) étant raccordée à la deuxième électrode du premier transistor (M1), une première électrode du huitième transistor (M8) étant raccordée à un port d'entrée du signal d'horloge, et une deuxième électrode du huitième transistor (M8) étant raccordée à un deuxième port du premier condensateur, et un point de raccordement raccordant la deuxième électrode du huitième transistor (M8) et le deuxième port du premier condensateur formant le deuxième port de sortie,
un premier port du condensateur étant raccordé à la deuxième électrode du premier transistor (M1), et
un point de raccordement raccordant la deuxième électrode du premier transistor (M1), l'électrode de commande du troisième transistor (M3), l'électrode de commande du huitième transistor (M8) et le premier port du premier condensateur formant le point de rappel vers le niveau haut ;
le module de commande de rappel vers le niveau bas (2) incluant un quatrième transistor (M4), un cinquième transistor (M5), un sixième transistor (M6) et un neuvième transistor (M9),
une électrode de commande du quatrième transistor (M4) étant raccordée au port d'entrée du signal d'horloge, une première électrode du quatrième transistor (M4) étant raccordée à une électrode de commande du sixième transistor (M6), et une deuxième électrode du quatrième transistor (M4) étant raccordée à un port d'entrée du troisième signal de tension continue,
une électrode de commande et une première électrode du cinquième transistor (M5) étant chacune raccordées au port d'entrée du deuxième signal de tension continue, et une deuxième électrode du cinquième transistor (M5) étant raccordée à l'électrode de commande du sixième transistor (M6),
une première électrode du sixième transistor (M6) étant raccordée au port d'entrée du deuxième signal de tension continue, et une deuxième électrode du sixième transistor (M6) étant raccordée au module de rappel vers le niveau bas (3), et
une électrode de commande du neuvième transistor (M9) étant raccordée à la deuxième électrode du premier transistor (M1) du module d'entrée (1), une première électrode du neuvième transistor (M9) étant raccordée au module de rappel vers le niveau bas (3), et une deuxième électrode du neuvième transistor (M9) étant raccordée au port d'entrée du troisième signal de tension continue,
le module de rappel vers le niveau bas (3) incluant un septième transistor (M7), un dixième transistor (M10) et un onzième transistor (M11),
une électrode de commande du septième transistor (M7) étant raccordée à la deuxième électrode du sixième transistor (M6), une première électrode du septième transistor (M7) étant raccordée au deuxième port du premier condensateur du module de rappel vers le niveau haut (4), et une deuxième électrode du septième transistor (M7) étant raccordée au port d'entrée du troisième signal de tension continue,
une électrode de commande du dixième transistor (M10) étant raccordée à la deuxième électrode du sixième transistor (M6), une première électrode du dixième transistor (M10) étant raccordée à l'électrode de commande du troisième transistor (M3) du module de rappel vers le niveau haut (4), et une deuxième électrode du dixième transistor (M10) étant raccordée au port d'entrée du troisième signal de tension continue,
une électrode de commande du onzième transistor (M11) étant raccordée à la deuxième électrode du sixième transistor (M6), une première électrode du onzième transistor (M11) étant raccordée à la deuxième électrode du troisième transistor (M3), et une deuxième électrode du onzième transistor (M11) étant raccordée au port d'entrée du troisième signal de tension continue, et
un point de raccordement raccordant l'électrode de commande du septième transistor (M7), la première électrode du neuvième transistor (M9), la deuxième électrode du sixième transistor (M6), l'électrode de commande du dixième transistor (M10) et l'électrode de commande du onzième transistor (M11) formant un point de rappel vers le niveau bas (PD).

2. Unité de registre à décalage selon la revendication 1, dans laquelle le module de réinitialisation (5) inclut un deuxième transistor (M2), une électrode de commande du deuxième transistor (M2) étant raccordée à un port d'entrée du signal de réinitialisation, une première électrode du deuxième transistor (M2) étant raccordée à l'électrode de commande du troisième transistor (M3), et une deuxième électrode du deuxième transistor (M2) étant raccordée à un port d'entrée du quatrième signal de tension continue.

3. Unité de registre à décalage selon la revendication 2, dans laquelle tous les transistors allant du premier transistor (M1) au onzième transistor (M11) sont des transistors de type N, ou bien
tous les transistors allant du premier transistor (M1) au onzième transistor (M11) sont des transistors de type P, ou bien
une partie des transistors allant du premier transistor (M1) au onzième transistor (M11) sont des transistors de type P, et les autres sont des transistors de type N.

4. Circuit d'attaque de grille comprenant une pluralité d'unités de registre à décalage selon l'une quelconque des revendications 1 à 3, dans lequel la pluralité d'unités de registre à décalage sont raccordées en cascade,
le module d'entrée (1) d'une unité de registre à décalage recevant en entrée le signal de sortie émis par le deuxième port de sortie d'un étage d'unité de registre à décalage précédent, et le module de réinitialisation (5) de l'unité de registre à décalage recevant un signal de sortie émis par le deuxième port de sortie d'un étage d'unité de registre à décalage suivant.

5. Dispositif d'affichage comprenant un circuit d'attaque de grille selon la revendication 4.

6. Procédé d'attaque pour attaquer une unité de registre à décalage selon l'une quelconque des revendications 1 à 3, comprenant :
- une phase de pré-sortie : produisant un signal de démarrage efficace qui est une impulsion de niveau haut du signal de démarrage (VINPUT),
où le point de rappel vers le niveau haut est chargé, et une tension du point de rappel vers le niveau bas est au niveau bas, le premier port de sortie émet un signal de décalage dont la tension augmente progressivement, et une tension du deuxième port de sortie est au niveau bas,
- une phase de sortie : produisant un signal d'horloge efficace qui est une impulsion de niveau haut du signal d'horloge,
où la charge du point de rappel vers le niveau haut est achevée, et une tension du point de rappel vers le niveau haut est au niveau haut, la tension du point de rappel vers le niveau bas est maintenue au niveau bas, le premier port de sortie émet le signal de décalage au niveau haut, et le deuxième port de sortie émet le signal de démarrage pour un étage d'unité de registre à décalage suivant au niveau haut,
- une phase de réinitialisation : fournissant un signal de réinitialisation efficace qui est une impulsion de niveau haut du signal de réinitialisation,
où la tension du point de rappel vers le niveau haut est au niveau bas, et la tension du point de rappel vers le niveau bas est au niveau haut, la tension du deuxième port de sortie est réinitialisée au niveau bas, et le premier port de sortie émet le signal de décalage au niveau bas, et
- une phase de maintien : produisant le signal d'horloge efficace,
où la tension du point de rappel vers le niveau bas est maintenue au niveau haut, et le signal de décalage émis par le premier port de sortie et la tension du deuxième port de sortie sont maintenus au niveau bas ;
les transistors de l'unité de registre à décalage étant des transistors de type N, et
- dans la phase de pré-sortie, le signal de démarrage étant au niveau haut et le signal d'horloge étant au niveau bas, le premier transistor (M1) étant à l'état passant pour charger le point de rappel vers le niveau haut, le neuvième transistor (M9) étant à l'état passant pour rappeler vers le niveau bas la tension du point de rappel vers le niveau bas, le huitième transistor (M8) étant à l'état passant, la tension du deuxième port de sortie étant au niveau bas, et le premier port de sortie émettant le signal de décalage dont la tension augmente progressivement,
- dans la phase de sortie, le signal de démarrage étant au niveau bas et le signal d'horloge étant au niveau haut, le huitième transistor (M8) recevant en entrée la tension du point de rappel vers le niveau haut au niveau haut, la tension du point de rappel vers le niveau haut continuant à être rappelée vers le niveau haut et le troisième transistor (M3) étant à l'état passant, les tensions du premier port de sortie et du deuxième port de sortie étant au niveau haut, et le neuvième transistor (M9) continuant à être à l'état passant pour maintenir au niveau bas la tension du point de rappel vers le niveau bas,
- dans la phase de réinitialisation, le signal d'horloge et le signal de démarrage étant au niveau bas, le signal de réinitialisation étant au niveau haut, la tension du point de rappel vers le niveau haut étant au niveau bas, le troisième transistor (M3) et le neuvième transistor (M9) étant à l'état non-passant, la tension du point de rappel vers le niveau bas passant au niveau haut, le septième transistor (M7), le dixième transistor (M10) et le onzième transistor (M11) étant à l'état passant, le septième transistor (M7) rappelant vers le niveau bas la tension du deuxième port de sortie, le dixième transistor (M10) rappelant vers le niveau bas la tension du point de rappel vers le niveau haut, le onzième transistor (M11) rappelant vers le niveau bas la tension du premier port de sortie, et le premier port de sortie émettant le signal de décalage au niveau bas,
- dans la phase de maintien, le signal d'horloge étant au niveau haut, la tension du point de rappel vers le niveau bas étant au niveau haut, le septième transistor (M7), le dixième transistor (M10) et le onzième transistor (M11) étant maintenus à l'état passant pour stabiliser la tension du point de rappel vers le niveau haut et maintenir le signal de décalage émis par le premier port de sortie au niveau bas.

7. Procédé d'attaque selon la revendication 6, dans lequel le premier signal de tension continue et le quatrième signal de tension continue sont des signaux de tension continue de polarités opposées, le deuxième signal de tension continue est un signal de tension positive et le troisième signal de tension continue est un signal de tension négative.
